# EUROPEAN PATENT APPLICATION

(11) **EP 1 688 934 A2**
(43) Date of publication of application: **09.08.2006**
(21) Application number: 06100791.0
(22) Date of filing: 24.01.2006
(51) Int. Cl.: G11B 7/08, G11B 7/22

(54) **An optical unit, an optical pick-up apparatus and a method of adjusting an optical axis**

(30) Priority: 27.01.2005 KR 200507709
(71) Applicant: SAMSUNG ELECTRONICS CO., LTD., Suwon-si, Gyeonggi-do (KR)
(72) Inventor: Lee, Moon-whan, Sanghyeong-dong Yongin-si (KR); Kim, Bong-gi, -dong Yeongtong-gu Gyeonggi-do Suwon-si (KR)
(74) Representative: Waddington, Richard

(57) **Abstract**

An optical unit is provided for an optical pick-up apparatus which includes a light source (20) to emit light entering into a recording medium. A light source holder (40) has an optical passage hole formed corresponding to a direction of a reference optical axis of the light toward the recording medium. A plate part (43) is coupled to a pickup base (30) and a holding part (41) supports the light source (20). The plate part (43) and the pickup base (30) are integrally formed with each other and an adjustable member adjusts the optical axis of the light source (20) by transforming the holding part (41).

## Description

The present invention relates to an optical unit capable of adjusting a direction of an optical axis of light from a light source. More particularly, the present invention relates to an optical pick-up apparatus including the same, and a method of adjusting an optical axis.

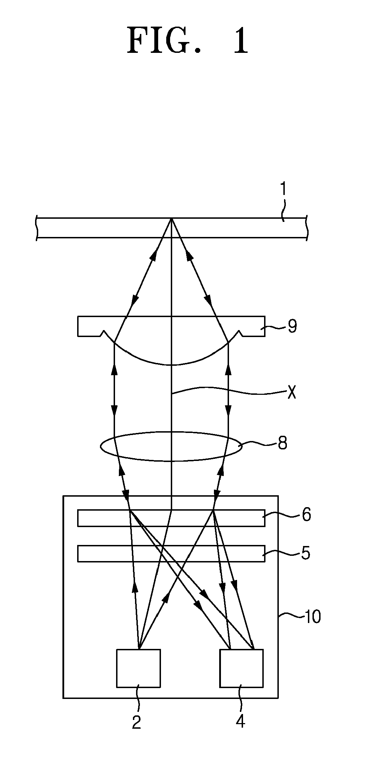

Generally, FIG. 1 illustrates a conventional optical pick-up apparatus for recording information or reproducing the recorded information with respect to an optical recording medium such as CD, DVD, or BD, using a light.

FIG. 1 shows the conventional optical pick-up apparatus employing a hologram element, which includes a light source 2, an objective lens 9, a hologram element 6, and an optical detector 4 placed along an optical path.

The light source 2 is a semiconductor laser diode which emits a predetermined wavelength of light. The objective lens 9 focuses the projected light to form an optical spot on an optical disc 1. The hologram element 6 is formed with a predetermined pattern such that light from the light source 2 linearly passes, while the light reflected from the optical disc is diffracted at a predetermined angle. Accordingly, the optical detector 4 receives the light reflected on the optical disc 1 and diffracted to the hologram element 6 to detect an information signal and/or an error signal.

A detecting member 5, such as a diffraction grating, is provided which detects a tracking error signal to split incident light into three beams. A collimating lens 8 is also provided for changing divergent rays from the light source 2 into parallel rays.

In the above-described structure, the light source 2 may be employed as an integrated chip, for example, a laser diode module 10, in which the hologram element 6, the diffraction grating 5, and an optical detector 4 are combined in order to provide a light-weight and smaller sized optical pick-up apparatus.

In the above-described structure, in order to record information at the optical disc, the light from the light source needs to be focused as a light spot on an exact location. Accordingly, the light source 2 or the light source module 10 should be adjusted in a radial direction of the disc 1. This would allow a center axis X of the light to enter into a center of lenses 8, 9.

There are drawbacks with the conventional apparatus. For example, in the above-described structure, distortion or separation among components can be caused by the heat from luminescence of the light source. Additionally, the apparatus utilizes a multitude of components and is relatively complex.

An object of the present invention is to address at least the above problems and/or disadvantages and to provide at least the advantages described below.

Accordingly, an object of the present invention is to provide an optical unit which adjusts a direction of an optical axis of a light projected from a light source and an optical pick-up apparatus having the same.

According to the present invention there is provided an apparatus and method as set forth in the appended claims.

Preferred features of the invention will be apparent from the dependent claims, and the description which follows.

According to an aspect of the present invention, there is provided the optical unit which comprises a light source to emit light entering into a recording medium. A light source holder preferably includes a light passage hole formed which corresponds to a direction of a reference optical axis of the light toward the recording medium. A plate part is preferably coupled to a pick-up base and a holding part preferably supports the light source. The plate part and the holding part are preferably integrally formed with each other. An adjusting member is preferably adapted to adjust an optical axis of the light source by transforming the holding part.

It is preferred that the holding part and the plate part are spaced apart a predetermined gap in the direction of a reference optical axis.

The adjusting member may comprise an adjusting screw coupled to each of the holding part and the plate part configured to transform the holding part by adjusting the gap according to a rotating direction.

Preferably, the holding part is formed of elastically transformable materials by external force.

The holding part may be formed with a light source mounting recess connected to the light passage hole and the light source is mounted to a position allowing the light emitted from the light source to be formed at a predetermined angle with respect to the reference optical axis.

The light source mounting recess may comprise a bottom and an inner circumferential surface and the inner circumferential surface maybe at a predetermined angle with the respect to an inner circumferential surface of the light passage hole.

Preferably, the holding part is formed with a light source mounting recess connected to the light passage hole and the light source can be mounted to a position allowing the light emitted from the light source to deviate away from the direction of the reference optical axis of the light.

The light source mounting recess may have a bottom forming a predetermined angle with respect to the direction of a reference optical axis of the light.

The adjusting member may be operable to move the holding part in relation to the plate part in order to approach to the bottom of the light source mounting recess in a perpendicular direction to the optical axis.

The adjusting member may comprise an adjustable screw coupled to the holding part and the plate part.

According to another aspect of the present invention, there is provided an optical pick-up apparatus which comprises a light source operable to emit light entering into a recording medium. A base preferably supports a plurality of optical components which form a route for the light. A light source holder preferably includes a light passage hole formed which corresponds to a direction of a reference optical axis of the light toward the recording medium. A plate part is coupled to the base and a holding part supports the light source. An adjusting member is preferably operable to adjust the optical axis of the light source by transforming the holding part.

According to another aspect of the present invention, there is provided a method of adjusting the optical axis by an optical pick-up apparatus. The method preferably comprises the steps of mounting a light source at a holder such that a light is emitted in a deviating manner away from a reference optical axis and adjusting a position of the light source mounted at the holder so that the emitted light can be aligned parallel with the reference optical axis.

The step of adjusting may include changing the position of the light source with respect to the direction of the reference optical axis.

The holder may comprise a light passage hole formed in the reference optical axis of the light, a holding part mounting the light source, and a plate part coupled to an optical pick-up base. The step of adjusting may forcibly transform the holding part to approach to one side of the plate part.

The step of adjusting may comprise rotating adjustable screws respectively coupled to the holding part and the plate part toward one direction.

Other objects, advantages, and salient features of the invention will become apparent to those skilled in the art from the following detailed description, which, taken in conjunction with the annexed drawings, discloses exemplary embodiments of the invention.

For a better understanding of the invention, and to show how embodiments of the same may be carried into effect, reference will now be made, by way of example, to the accompanying diagrammatic drawings in which:
FIG. 1 is a view of the structure schematically showing a general conventional optical pick-up apparatus.
FIG. 2 is a sectional view of the structure schematically showing an optical pick-up apparatus according to an embodiment of the present invention.
FIG. 3 is a sectional view showing a light source mounted on the holder of FIG. 2.
FIG. 4 is a sectional view showing an optical axis adjusted by rotating an adjusting screw of FIG. 3.

Throughout the drawings, the same drawing reference numerals will be understood to refer to the same elements, features, and structures.

Accordingly, there is a need for an improved optical unit which adjusts a direction of an optical axis of a light projected from a light source and an optical pick-up apparatus having the same while preventing distortion or separation among components by the heat from a light source and which is relatively simple to use.

The matters defined in the description such as a detailed construction and elements are provided to assist in a comprehensive understanding of the embodiments of the invention. Accordingly, those of ordinary skill in the art will recognize that various changes and modifications of the embodiments described herein can be made without departing from the scope and spirit of the invention. Also, descriptions of well-known functions and constructions are omitted for clarity and conciseness.

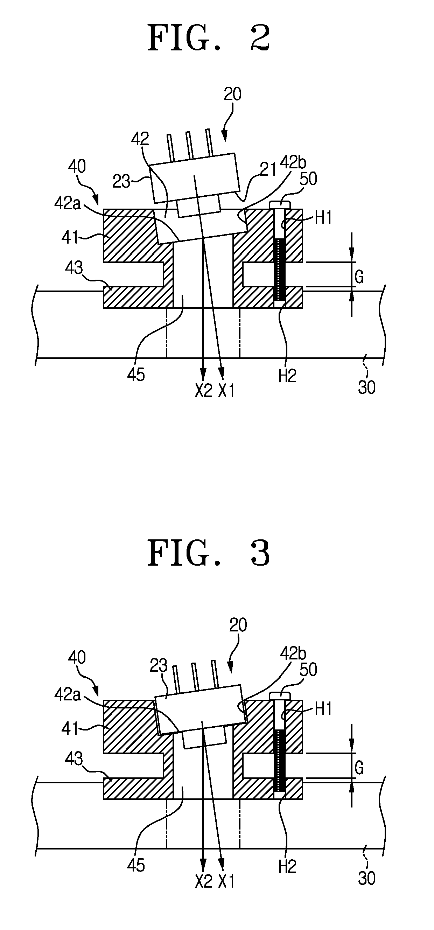

Referring to FIG. 2, the optical pick-up apparatus according to an embodiment of the present invention comprises a light source 20 to emit light to enter into an optical recording medium, a pick-up base 30, a holder 40 for supporting the light source 20, and an adjusting member 50 for adjusting an optical axis of the light.

The light source 20 comprises a semiconductor laser diode for emitting the light of a predetermined wavelength. As shown in FIG. 1, the light source 20 may comprise a light source module mounting including predetermined optical components. The light source 20 can be arranged to correspond to an optical axis (X1) of a light projected from the light source 20. A predetermined reference optical axis (X2) is arranged so that the light from the light source 20 can be relatively precisely formed at a desired position of an optical recording medium.

The pick-up base 30 supports several optical components to form a route of the light, including the light source 20 and the holder 40. The pickup base 30 is mounted within an optical disc player such as CD player or DVD player. The pickup base is movable in a direction of a radius of the optical disc with the optical pick-up mounted. Since composition and operation of such a pickup base 30 are well known in the art, a detailed description thereof is omitted for clarity and conciseness.

The holder 40 may be coupled to the pickup base 30 by an adhesive such as UV bond or separate clamps. The holder 40 has a holding part 41 for supporting the light source 20 and a plate part 43 connected to the pickup base 30.

The holder 40 is formed with a light passage hole 45 with its center aligned to the reference optical axis (X2). The light passage hole 45 penetrates from a front end of the holder 40 to a rear end. The holding part 41 and the plate part 43 are formed to have a predetermined distance of gap (G) in a direction of the reference optical axis (X2) .

The holding part 41 is formed with a light source mounting recess 42 to receive the light source 42. The light source mounting recess 42 is connected to the light passage hole 45. The light source mounting recess 42 has a bottom 42a for supporting a front end 21 of the light source 20 and an inner surface 42b for supporting an outer surface 23 of the light source 20. The bottom 42a is constructed so as to be not perpendicular to the reference optical axis (X2), but disposed at a predetermined angle with the respect to it. The inner surface 42b is formed at a predetermined angle with respect to the optical passage hole 45. Accordingly, when the light source 20 is mounted at the light source mounting recess 42, as shown in FIG. 3, the axis (X1) of emergent light from the light source 20 is not parallel to the reference optical axis (X2), but is formed at a predetermined angle with the respect to it.

As described above, the light source 20 mounted at the light source mounting recess 42 of the holding part 41 is adjusted by the adjusting member 50 of an optical axis such that the optical axis (X1) and the reference optical axis (X2) correspond to each other. The adjusting member 50 comprises an adjusting screw for being coupled to each of the holding part 41 and the plate part 43. Each of the holding part 41 and the plate part 43 is formed with screw hole (H1, H2) for coupling with the adjusting screw 50. Each screw hole (H1, H2) is formed corresponding to each other, and in alignment with the reference optical axis (X2). Accordingly, if the adjusting screw 50 coupled to the screw holes (H1, H2) is rotated in a screw tightening direction, the holding part 41 and the plate part 43 approach each other, to reduce a gap (G) of one side and increase that of the other side.

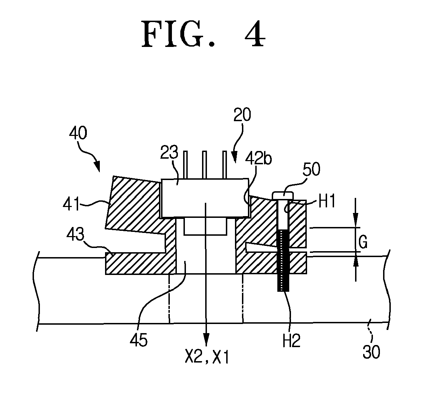

Since the plate part 43 is fixed at the pick-up base 30, the holding part 41 is forced to be transformed by the tightening force of the adjusting screw 50 so as to be bent towards the adjusting screw 50, as shown in FIG. 4. Accordingly, the position of the light source 20 mounted at the holding part 41 changes and it is enabled to adjust the optical axis projected (X1) to correspond to the reference optical axis (X2). Since the holding part 41 is transformable, not in a loosening direction of the adjustable screw 50, but in a tightening direction, the light source mounting recess 42 is formed in a manner as shown in FIG. 1. Thus, the light source 20 can be initially mounted to tilt to one side.

In the above-described structure, the holder 40 preferably comprises plastics or synthetic resins minutely transformable by force generated via tightening of the adjustable screw 50.

Hereinbelow, a method for adjusting an optical axis using an optical pick-up apparatus having the above structure will be described in greater detail, according to an embodiment of the present invention.

As shown in FIG. 2, there is provided the holder 40 having the light source mounting recess 42 angled with the respect to the light passage hole 45.

Then, the light source 20 is mounted on the light source mounting recess 42 at a predetermined inclination. The light source 20 may be fixed by suitable arrangements such as bond in the light source mounting recess 42. Accordingly, the optical axis (X1) of the light from the light source 20 does not correspond to the reference optical axis (X2), but, deviates at a predetermined angle, as shown in FIG. 3.

As described above, the holder 40 mounting the light source 20 is fixed on the pick-up base 30 by an adhesive such as UV bond, screws, or elastic clamps.

If the adjustable screw 50 is rotated towards the tightening direction little by little, the right side of the holding part 41 is minutely transformed by the force generated by tightening the adjustable screw 50. Accordingly, the gap (G) of the right side is narrowed, while increasing the gap on the left side, to change the position of the light source 20. By this process, the adjustable screw 50 is tightened until the optical axis (X1) of the light from the light source 20 corresponds to the reference optical axis (X2), as shown in FIG. 4.

That is, the light source 20 is correctly located with the respect to the reference optical axis (X2) . Moreover, the two optical axes (X1, X2) correspond to each other to complete the adjustment of the optical axis.

As can be appreciated from the above description, with an optical unit, an optical pick-up apparatus and a method of adjusting an optical axis according to the embodiments of the present invention, the light source 20 is mounted on the holder 40 with the holding part 41 and the plate part 43 being integrally formed to require fewer optical components. Accordingly, it is more reliable in that the distortion or separation among components by the heat from luminescence of the light source can be prevented.

It is also relatively convenient and easy to operate because the optical axis is adjusted by the simple operation of rotating the adjustable screw with respect to the holder 40.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An optical unit for an optical pick-up comprising:
a light source (20) operable to emit light entering into a recording medium;
a light source holder (40) including a light passage hole (45) formed corresponding to a direction of a reference optical axis of the light toward the recording medium;
a plate part (43) coupled to a pick-up base (30) and a holding part (41) which supports the light source (20) integrally formed with each other; and
an adjusting member (50) operable to adjust an optical axis of the light source (20) by transforming the holding part (41).

2. The optical unit for an optical pick-up of claim 1, wherein the holding part (41) and the plate part (43) are spaced apart a predetermined gap in the direction of the reference optical axis.

3. The optical unit for an optical pick-up of claim 2, wherein the adjusting member (50) comprises an adjustable screw coupled to each of the holding part (41) and the plate part (43) configured to transform the holding part (41) by adjusting the gap according to a rotating direction.

4. The optical unit for an optical pick-up of any preceding claim, wherein the holding part (41) is formed of materials elastically transformable by external force.

5. The optical unit for an optical pick-up of claim 4, wherein the holding part (41) is formed with a light source mounting recess (42) connected to the light passage hole (45) and the light source (20) is mounted to a position allowing the light emitted from the light source (20) to be formed at a predetermined angle with respect to the reference optical axis.

6. The optical unit for an optical pick-up of claim 4 or claim 5, wherein the light source mounting recess (42) comprises a bottom (42a) and an inner (42b) circumferential surface and the inner circumferential surface (42b) is at a predetermined angle with the respect to an inner circumferential surface of the light passage hole (45).

7. The optical unit for an optical pick-up of any preceding claim, wherein the holding part (41) is formed with a light source mounting recess (42) connected to the light passage hole (45) and the light source (20) is mounted to a position allowing the light emitted from the light source (20) to deviate away from the direction of the reference optical axis of the light.

8. The optical unit for an optical pick-up of claim 7, wherein the light source mounting recess (42) has a bottom (42a) forming a predetermined angle with respect to the direction of a reference optical axis of the light.

9. The optical unit for an optical pick-up of claim 8, wherein the adjusting member (50) is operable to move the holding part (41) relative to the plate part (43) in order to approach the bottom of the light source mounting recess (42) in a direction perpendicular to the optical axis.

10. The optical unit for an optical pick-up of claim 9, wherein the adjusting member (50) comprises an adjustable screw coupled to the holding part (41) and the plate part (43) .

11. An optical pick-up apparatus comprising:
a light source (20) operable to emit light entering into a recording medium;
a base (30) supporting a plurality of optical components forming a route for the light;
a light source holder (40) having a light passage hole (45) formed corresponding to a direction of a reference optical axis of the light toward the recording medium;
a plate part (43) coupled to the base (30) and a holding part (41) supporting the light source (20); and
an adjusting member (50) which is operable to adjust the optical axis of the light source (20) by transforming the holding part (41).

12. The optical pick-up apparatus of claim 11, wherein the adjusting member (50) comprises an adjustable screw coupled between the holding part (41) and the plate part (43) to forcibly transform the holding part (41) according to a rotating direction.

13. The optical pick-up apparatus of claim 11 or claim 12, wherein the holding part (41) is formed with a light source mounting recess (42) connected to the light passage hole (45), and the light source (20) is mounted to a position deviating away from the light passage hole (45).

14. The optical pick-up apparatus of claim 13, wherein the light source mounting recess (42) has a bottom forming a predetermined angle with the respect to the direction of the reference optical axis.

15. The optical pick-up apparatus of claim 14, wherein the adjusting member (50) is operable to forcibly transform the holder to a direction where the bottom is in perpendicular relation to the reference optical axis.

16. The optical pick-up apparatus of claim 15, wherein the adjusting member (50) comprises an adjustable screw coupled between the holding part (41) and the plate part (43) .

17. The optical pick-up apparatus of any one of claims 11 to 16, wherein a predetermined gap is formed between the holding part (41) and the plate part (43), and the holding part (41) is forcibly transformable by the adjusting member (50) toward a direction of narrowing the gap.

18. The optical pick-up apparatus of any one of claims 11 to 17, wherein the light source (20) comprises a laser diode.

19. A method of adjusting an optical axis by an optical pick-up apparatus comprising the steps of:
mounting a light source (20) on a holder such that a light is emitted in a deviating manner away from a reference optical axis; and
adjusting a position of the light source (20) mounted on the holder so that the emitted light can be aligned parallel with the reference optical axis .

20. The method of claim 19, wherein the step of adjusting changes the position of the light source (20) with respect to the reference optical axis by forcibly transforming a part of the holder.

21. The method of claim 19 or claim 20, wherein the holder comprises a light passage hole (45) formed in the reference optical axis of the light;
a holding part (41) mounting the light source (20), and a plate part (43) coupled to an optical pick-up base (30); and
the step of adjusting forcibly transforms the holding part (41) to approach one side of the plate part (43).

22. The method of claim 21, wherein the step of adjusting comprises rotating adjustable screws respectively coupled to the holding part (41) and the plate part (43) toward one direction.
